(19) Europäisches Patentamt
European Patent Office
Office européen des brevets

(11) Veröffentlichungsnummer: **0 200 680**
**A2**

# (12) EUROPÄISCHE PATENTANMELDUNG

(21) Anmeldenummer: **86810163.5**

(51) Int. Cl.⁴: **C08G 69/26** , G03F 7/10

(22) Anmeldetag: **07.04.86**

(30) Priorität: **11.04.85 CH 1551/85**

(43) Veröffentlichungstag der Anmeldung:
**10.12.86 Patentblatt 86/45**

(84) Benannte Vertragsstaaten:
**BE CH DE FR GB IT LI NL SE**

(71) Anmelder: **CIBA-GEIGY AG**
**Klybeckstrasse 141**
**CH-4002 Basel(CH)**

(72) Erfinder: **Pfeifer, Josef, Dr.**
**Brunnmattstrasse 32**
**CH-4106 Therwil(CH)**

## (54) Beschichtetes Material und dessen Verwendung.

(57) Beschichtetes lichtempfindliches Material aus einem Trägermaterial mit einer Schicht aus Polyamidsäuren und Polyamidsäurearylestern auf der Basis von Tetracarbonsäuren bzw. Aminodicarbonsäuren mit einem Benzophenonstrukturelement und aromatischen Diaminen, die in beiden Orthostellungen mindestens einer Aminogruppe substituiert sind. Das Material ist autophotovernetzbar und eignet sich zur Herstellung von Schutzüberzügen und photographischen Abbildungen, wobei nach der Bestrahlung durch thermische Einwirkung entsprechende Polyimide gebildet werden.

EP 0 200 680 A2

Rank Xerox

# Beschichtetes Material und dessen Verwendung

Die vorliegende Erfindung betrifft ein mit strahlungsempfindlichen Polyamidsäure-und/oder Polyamidsäurearylestern und/oder Polyamidsäureaminsalzen beschichtetes Material, und dessen Verwendung zur Herstellung von Schutzfilmen oder photographischen Reliefabbildungen.

Polyimide sind Kunststoffe mit wertvollen thermomechanischen Eigenschaften. Auf Grund ihrer hohen Schmelzbereiche können sie jedoch nicht mit den für Thermoplaste üblichen Formgebungsverfahren verarbeitet werden. Es sind daher lösliche Polyimide entwickelt worden, die als Lacke zur Bildung von Ueberzugsschichten mit hoher Wärmebeständikeit verwendet werden können, vgl. DE-AS 19 62 588 und US-PS 3,787,367. Mit der Entwicklung der Elektronik und Halbleitertechnologie werden an Polyimide z.B als Isolier-und Schutzfilme hohe Anforderungen gestellt. In der EP-A-O 132 221 sind lösliche Polyimide beschrieben, die durch Einwirkung von Strahlung vernetzt werden können. Zur Verbesserung der Löslichkeit ist es wünschenswert, über Polyamidsäuren und Ester zu verfügen, die auch photopolymerisierbar sind.

Gegenstand der Erfindung ist ein beschichtetes Material, bei dem auf mindestens einer Oberfläche eines Trägermaterials eine Schicht einer Polyamidsäure, eines Polyamidsäurearylesters und/oder eines Polyamidsäureaminsalzes oder Mischungen hiervon aufegbracht ist, die 50 bis 100 Mol-%, bezogen auf das Polymer, mindestens eines Strukturelementes der Formeln I oder II oder Mischungen hiervon,

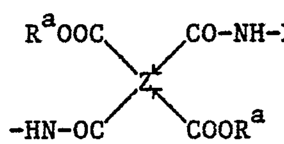
(I) ,

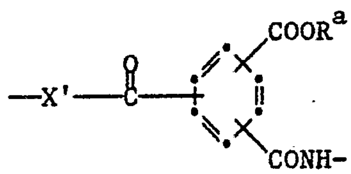
(II) ,

und

0 bis 50 Mol-% mindestens eines Strukturelementes der Formeln III oder IV oder Mischungen hiervon,

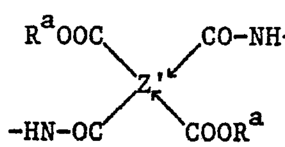
(III) ,

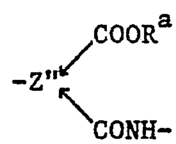
(IV),

enthalten, worin die Pfeile Stellungsisomerie bedeuten, $R^a$ ein Wasserstoffatom, Aryl, tertiäres Ammonium mit mindestens einem, aliphatischen oder araliphatischen Kohlenwasserstoffrest ist, oder Mischungen hiervon,

Z einen vierwertigen aromatischen Rest darstellt, der ein Benzophenonstrukturelement enthält, an den je eine -CONH-und $COOR^a$-Gruppe an einen oder zwei verschiedenen Phenylresten in Orthostellung oder Peristellung zueinander gebunden sind,

Z' für einen vierwertigen, von Z verschiedenen armoatischen Rest steht, an den je eine Ester-und Amidgruppe in Ortho-oder Peristellung zueinander gebunden sind

Z' einen dreiwertigen aromatischen Rest bedeutet, der vom Rest im Strukturelement der Formel II verschieden ist, und an den je eine Ester-und Amidgruppe in Ortho-oder Peristellung zueinander gebunden sind,

X den Rest eines aromatischen Diamines bedeutet, der in beiden Orthostellungen zu mindestens einem N-Atom durch Alkyl, Cycloalkyl, Alkoxy, Alkoxyalkyl oder Aralkyl substituiert ist, oder zwei benachbarte C-Atome des aromatischen Restes durch Alkylen substituiert sind,

X' ein zweiwertiger aromatischer Rest ist, der durch mindestens eine wie für X definierte Gruppe substituert ist, und

X" die gleiche Bedeutung wie X hat oder einen von X verschiedenen zweiwertigen Rest eines organischen Diamines darstellt.

Die Strukturelemente der Formeln I und/oder II sind bevorzugt in einer Menge von 60-100 Mol-% und insbesondere 80-100 Mol-% und die Strukturelemente der Formeln II und/oder IV bevorzugt in einer Menge von 40 bis 0 Mol-% und insbesondere 20 bis 0 Mol-% enthalten. Ferner können weniger als 50 Mol-% der Strukturelemente der Formeln I bis IV durch entsprechende Ester mit einer aliphatischen Gruppe im Esterrest ersetzt sein. Die aliphatische Gruppe ist bevorzugt $C_1$-$C_{12}$-Alkyl oder Benzyl.

$R^a$ enthält als Aryl bevorzugt 6 bis 12 C-Atome; bevorzugt handelt es sich um Phenyl, das durch $C_1$-$C_{12}$-Alkyl, $C_1$-$C_{12}$-Alkoxy, $C_1$-$C_{12}$-Alkylthio oder Halogen, besonders F, Cl oder Br susbtituiert sein kann.

$R^a$ als tertiäres Ammonium enthält bevorzugt 3 bis 20, besonders 3 bis 12 C-Atome, es entspricht insbesondere der Formel $HNR^sR^tR^u$, woring $R^s$ , $R^t$ und $R^u$ unabhängig veoneinander $C_1$-$C_{12}$-, besonders $C_1$-$C_6$-Alkyl, $C_3$-$C_{12}$-, besonders $C_5$-oder $C_6$-Cycloaklyl, das durch $C_1$-$C_6$-Alkyl substituiert sein kann, $C_6$-$C_{12}$-Aryl, dass durch $C_1$-$C_6$-Alkyl, $C_1$-$C_6$-Alkoxy substituiert sein kann, oder $C_7$-$C_{16}$-Aralkyl, das durch $C_1$-$C_6$-Alkyl oder $C_1$-$C_6$-Alkoxy substituiert sein kann, wobei mindestens einer der Reste $R^s$, $R^t$ oder $R^u$ Alkyl, Cycloalkyl oder Aralkyl ist. Das Aryl ist bevorzugt gegebenenfalls substituiertes Phenyl und das Aralkyl gegebenenfalls sustituiertes Benzyl.

Bevorzugte Asuführungsformen sind Trialkyl-, Dialkylphenyl-und Dialkylbenzylammonium mit 1 bis 6 C-Atomen im Alkyl. Beispiele für $R^s$, $R^t$ und $R^u$ sind Methyl, Ethyl, n-Propyl, i-Propyl, n-, i-und t-Butyl, Pentyl, Hexyl, Octyl, Cyclopentyl, Methylcyclopentyl, Cyclohexyl, Methylcyclohexyl, Phenyl, Methylphenyl, Dimethylphenyl, Ethylphenyl, Benzyl, Phenylethyl, und Methylbenzyl.

$R^a$ ist bevorzugt ein Wasserstoffatom oder tertiäres Ammonium mit mindestens einem aliphatischen, araliphatischen Kohlenwasserstoffrest.

Als aromatischer Rest stellt X bevorzugt einen zweiwertigen, ein-oder zweikernigen Phenylenrest dar. Die Substituenten von X können als lineares oder verzweigtes Alkyl und Alkoxy 1 bis 20, bevorzugt 1 bis 6 und besonders 1 bis 4 C-Atome, als lineares oder verzweigtes Alkoxyalkyl 2 bis 12, besonders 2 bis 6 C-Atome, als Alkylen 3 oder 4 C-Atome, als Cycloalkyl 5 bis 8, besonders 5 oder 6 Ringkohlenstoffatome und als Aralkyl 7 bis 12 C-Atome enthalten. Das Alkoxyalkyl ist bevorzugt Alkoxymethyl und das Aralkyl Benzyl.

Beispiele für Substituenten sind; Methyl, Aethyl, Propyl, Isopropyl, n-Butyl, Isobutyl, Tertiärbutyl, Pentyl, Hexyl, Octyl, Dodecyl, Tetradecyl, Eicosyl, Cyclopentyl, Cyclohexyl, Methylcyclohexyl, Methoxy, Aethoxy, Propoxy, Butoxy, Pentoxy, Hexoxy, Methoxymethyl, Methoxyäthyl, Aethoxymethyl, Propoxymethyl, Butoxymethyl, Benzyl, Methylbenzyl und Penylaethyl. Bevorzugte Reste sind Methoxymethyl, Aethoxymethyl, Methyl, Aethyl, Isopropyl, Trimethylen und Tetramethylen. Besonders bevorzugt ist Isopropyl, Aethyl und insbesondere Methyl.

X kann als substituierter aromatischer Rest 8 bis 30, besonders 8 bis 25 C-Atome enthalten. Der aromatische Rest ist bevorzugt ein Pyridinrest und besonders ein Kohlenwasserstoffrest, der durch Alkyl, Alkoxyalkyl, Alkoxy, Trimethylen oder Tetramethylen substituiert ist. Der aromatische Rest kann weitere Substituenten enthalten, z.B. Halogenid wie Cl oder Br. In einer bevorzugten Unterguppe sind die aromatischen Reste als einkernige Reste Phenylenreste und als zweikernige Reste Naphthylen oder Bisphenylenreste.

Eine bevorzugte Untergruppe von erfindungsgemäss zu verwendenden Polyamidsäuren und Polyamidsäurearylestern sind solche, in denen X als aromatischer Rest den Formeln VIII, VIIIa und/oder VIIIb entspricht,

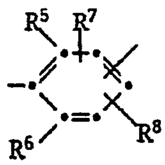 (VIII) , 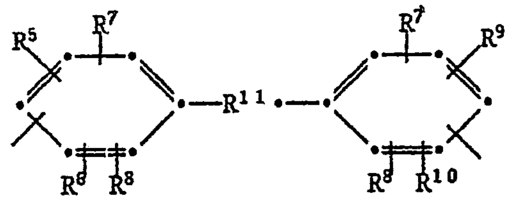 (VIIIa)

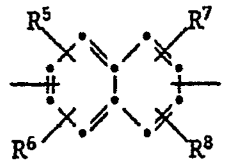 (VIIIb)

worin in Formel VIII die freie Bindungen in Meta- oder Parastellung zueinander stehen, in Formel VIIIa die freien Bindungen bevorzugt in Meta-oder Parastellung zur $R^{11}$-Gruppe stehen und $R^5$ und $R^6$ in den beiden Orthostellungen der freien Bindung gebunden sind, und in Formel VIIIb die freien Bindungen in 2-, 3-, 6-und 7-Stellung gebunden sind und $R^5$ und $R^6$ sich in den beiden Orthostellungen der freien Bindungen befinden, $R^{11}$ für eine direkte Bindung, -O-, -S-, -SS-, -SO-, $-SO_2-$, -CO-, -COO-, -NH-, -N-Alkyl mit 1 bis 6 C-Atomen im Alkyl, -N -Phenyl, - N -Benzyl, -CONH-, -CON-Alkylmit 1 bis 6 C-Atomen im Alkyl, -CON-Phenyl-, -CON-Benzyl-,

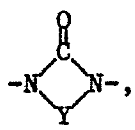, worin Y für 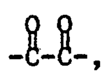, 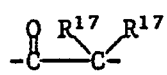 oder 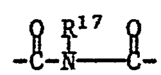 steht

und $R^{17}$ ein Wasserstoffatom, $C_1$-$C_6$-Alkyl oder Phenyl bedeutet, lineares oder verzweigtes Alkylen mit 1 bis 3 C-Atomen, gegebenenfalls durch Cl oder F substituiertes Alkyliden mit 2 bis 12 C-Atomen, Cycloalkyliden mit 5 oder 6 Ringkohlenstoffatomen, Phenylen, Phenylendioxy, oder die Gruppe 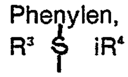

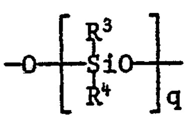 oder 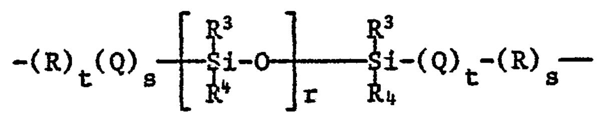 steht,

worin $R^3$ und $R^4$ Alkyl oder Alkoxy mit 1 bis 6 C-Atomen, Phenyl, Benzyl, Phenyloxy oder Benzyloxy sind, r eine Zahl von 1 bis 10, t 0 oder 1 und S 0 oder 1 ist, und R -O-oder -S-und Q $C_1$-$C_6$-Alkylen bedeuten, und q für eine Zahl von 1 bis 100 steht, R $^5$ und $R^6$ Alkyl, oder Alkoxy mit 1 bis 12 C-Atomen, Alkoxyalkyl mit 2 bis 12 C-Atomen, Cyclopentyl, Cyclohexyl oder Benzyl sind oder in den Formeln VIII oder VIIIa $R^5$ und $R^7$ in Nachbarstellung gebunden sind und zusammen Trimethylen oder Tetramethylen bedeuten , wobei $R^6$ auch ein Wasserstoffatom sein kann, $R^7$ und $R^8$ ein Wasserstoffatom sind oder unabhängig die Bedeutung von $R^5$ und $R^6$ haben, und $R^9$ and $R^{10}$ein Wasserstoffatom sind, unabhängig die Bedeutung von $R^5$ und $R^6$haben oder $R^7$ und $R^9$ in Formel VIIIa zusammen Trimethylen oder Tetramethylen sind. $R^5$ und $R^6$ sind bevorzugt Alkyl mit 1 bis 6 C-Atomen, besonders Methyl, Aethyl, n-Propyl und Isopropyl. Das Alkyl in den $R^{11}$-Resten kann z.B. Methyl, Aethyl, Propyl, Isopropyl, n-Butyl oder Pentyl sein. $R^{11}$ als Alkylen ist bevoruzugt Aethylen und besonders Methylen. als Alkyliden enthält $R^{11}$ bevorzugt 2 bis 6 C-Atome. Beispiele sind Aethyliden, 2,2-Butyliden, 2,2-oder 3,3-Pentyliden, Hexafluropropyliden und besonders 2,2-Propyliden. R $^{11}$ als Cycloalkyliden kann z.B. Cyclopentyliden und besonders Cyclohexyliden sein. Die $R^{11}$-Gruppe ist

bevorzugt eine direkte Bindung, -O-, -S-, $-SO_2-$, -CO-, Alkylen und Alkyliden. Besonders bevorzugt ist $R^{11}$ eine direkte Bindung, -O-, und insbesondere -CO-oder $-CH_2-$. $R^3$ und $R^4$ sind bevorzugt Alkyl, besonders Methyl, oder Phenyl. R steht bevorzugt für -O-und Q bevorzugt für Methylen oder Aethylen, q ist bevorzugt eine Zahl von 1 bis 10 und r eine Zahl von 1-20, besonders 1-10. eine weitere Gruppe von Diaminresten X sind solche der Formel

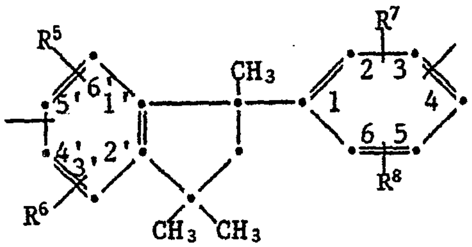

worin die freie Bindung in 4'-oder 5'-Stellung gebunden ist und die andere in 3-, 5-, und bevorzugt 4-Stellung, $R^5$ und $R^6$ und/oder $R^7$und $R^8$ sich in den Orthostellungen der freien Bindung befinden und für Alkyl oder Alkoxy mit 1 bis 12 C-Atomen oder Alkoxyalkyl mit 2 bis 12 C-Atomen stehen.

Eine besonders bevorzugte Untergruppe von Strukturelementen sind jene, in denen X in Formel I Resten der Formeln

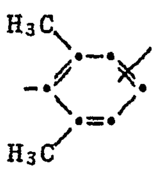 , 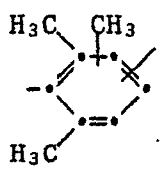 , 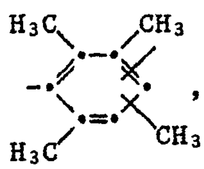 , 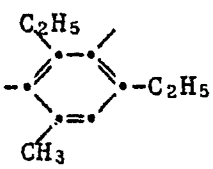

entsprechen, worin die freien Bindungen in Meta- oder Parastellung zueinander stehen, oder der Formel

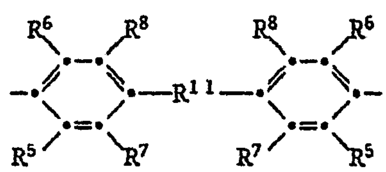

entsprechen, worin $R^5$ und $R^6$ unabhängig Methyl, Aethyl, n-Propyl oder Isopropyl und $R^7$ und $R^8$ ein Wasserstoffatom sind oder die Bedeutung von $R^5$ haben, oder $R^5$ und $R^7$ zusammen Tri-oder Tetramethylen bedeuten und $R^6$ und $R^8$ ein Wasserstoffatom sind, und $R^{11}$eine direkte Bindung, $CH_2$, 2,2-Propyliden oder CO ist. Unter diesen zweikernigen Resten sind besonders solche bevorzugt, in denen $R^5$, $R^6$, $R^7$ und $R^8$ für Methyl stehen. Ein beschichtetes Material, das mindestens 2 verschiedene Reste dieser Formeln als Strukturelemente der Formel I enthält, ist eine weitere bevorzugte Ausführungsform der Erfindung.

Erfindungsgemäss zu verwendende Copolyamidsäuren, -arylester und t-ammoniumsalze enthalten mindestens zwei verschiedene Strukturelemente, wobei sich die Anzahl an verschiedenen Strukturelementen im wesentlichen nach den gewünschten Eigenschaften und dem Anwendungsgebiet richten. Bevorzugt enthalten sie 2 bis 4 verschiedene Strukturelemente, wobei sich die Strukturelemente nur im Rest X Formel I unterscheiden können. In einer besonders bevorzugten Ausführungsform sind Strukturelemente von orthodisubstituierten Phenylenen besonders von 1,3-Phenylenen und/oder orthosubstituierten, gegebenenfalls eine Brückengruppe enthaltende Diphenylene enthalten.

Beispiele für X sind:

2,6-Dimethyl-1,4-oder 1,3-phenylen, 2,6-Diäthyl-1,4-oder 1,3-phenylen, 2,6-Diemthyl-5-chlor-1,4-oder 1,3-phenylen, 2-Methyl-6-äthyl-1,4-oder 1,3-phenylen, 2-Methyl-6-isopropyl-1,4-oder 1,3-phenylen, 2,6-Diispropyl-1,4-oder 1,3-phenylen, 2,6-Dimethoxy-1,4-oder 1,3-phenylen, 2,6-Diäthoxy-1,4-oder 1,3-phenylen, 2-Methyl-6-methoxy-1,4-oder 1,3-phenylen, 2,6-Dibenzyl-1,4-oder 1,3-phenylen, 2,6-Dimethoxymethyl-1,4-oder 1,3-phenylen, 2,5,6-Trimethyl-1,4-oder 1,3-phenylen, 2,5,6-Triäthyl-1,4-oder 1,3-phenylen, 2,4,6-Trimethyl-1,3-phenylen, 2,3,5,6-Tetramethyl-1,4-phenylen, 2,4,5,6-Tetramethyl-1,3-phenylen, Tetrahydro-1,4-oder 1,3-naphthylen, Reste der Formeln

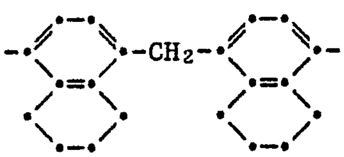 ,

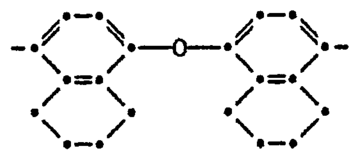

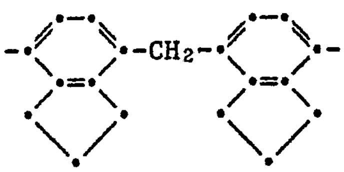 ,

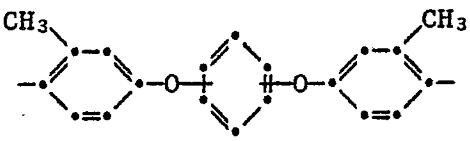 ,

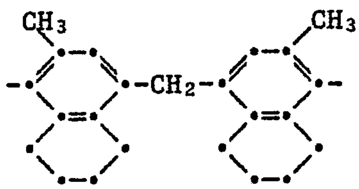 ,

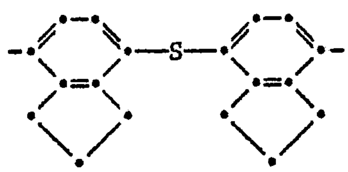 ,

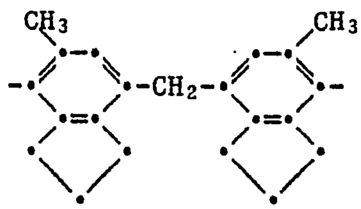
,
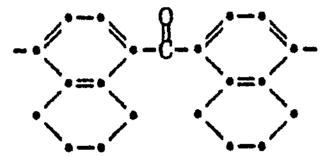
,

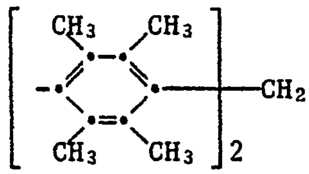

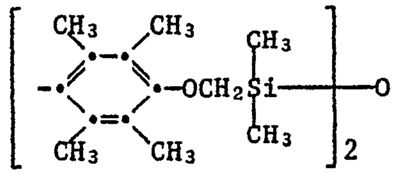

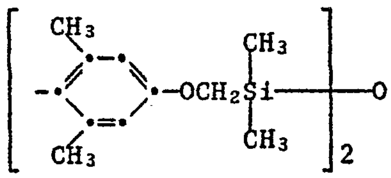
,

sowie

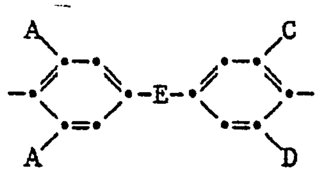
,
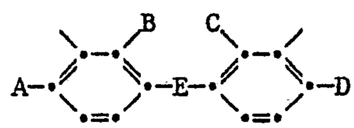

und
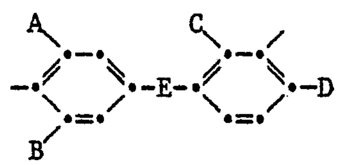
,

worin A, B, C, D und E die in nachfolgender Tabelle angegebenen Bedeutungen haben. Die freien Positionen in den Phenylkernen der letzten drei Formeln können hierbei durch einen oder zwei weitere Substituenten G oder H in jedem Kern besetzt sein, wobei G oder H die Bedeutung von A oder B in nachfolgender Tabelle haben können:

| E | A | B | C | D |
|---|---|---|---|---|
| $CH_2$ | Methyl | Methyl | H | H |
| $CH_2$ | Methyl | Ethyl | H | H |
| $CH_2$ | Ethyl | Ethyl | H | H |
| $CH_2$ | Isopropyl | Isopropyl | H | H |
| $CH_2$ | Methoxymethyl | | H | H |
| $CH_2$ | Benzyl | Benzyl | H | H |
| $CH_2$ | Methyl | Methyl | Methyl | H |
| $CH_2$ | Ethyl | Ethyl | Ethyl | H |
| $CH_2$ | Isopropyl | Isopropyl | Methyl | Methyl |
| $CH_2$ | Methoxymethyl | | Methyl | H |
| $CH_2$ | Methyl | Ethyl | Methyl | H |
| $CH_2$ | Methoxymethyl | | Methoxymethyl | |
| $CH_2$ | Methyl | Methyl | Methyl | Methyl |
| $CH_2$ | Ethyl | Ethyl | Ethyl | Ethyl |
| $CH_2$ | Methyl | Methyl | Ethyl | Ethyl |
| $CH_2$ | Ethyl | Ethyl | Isopropyl | Isopropyl |
| $CH_2$ | Isopropyl | Isopropyl | Isopropyl | Isopropyl |
| $CH_2$ | Isopropyl | Isopropyl | Methyl | H |
| $CH_2$ | Methoxy | Methoxy | Methyl | Methyl |
| O | Methyl | Methyl | H | H |
| O | Ethyl | Ethyl | H | H |
| O | Methyl | Methyl | Methyl | H |
| O | Methyl | Methyl | Methyl | Methyl |
| O | Methyl | Methyl | Ethyl | Ethyl |
| S | Methyl | Methyl | H | H |
| S | Ethyl | Ethyl | H | H |
| S | Methyl | Methyl | H | H |
| S | Methyl | Methyl | Methyl | Methyl |
| S | Ethyl | Ethyl | Ethyl | Ethyl |
| S | Methyl | Methyl | Ethyl | Ethyl |
| CO | Methyl | Methyl | Methyl | H |
| CO | Methyl | Methyl | H | H |

| E | A | B | C | D |
|---|---|---|---|---|
| CO | Methyl | Methyl | Methyl | Methyl |
| $SO_2$ | Methyl | Methyl | Ethyl | H |
| $SO_2$ | Methyl | Methyl | H | H |
| $SO_2$ | Methyl | Methyl | Methyl | Methyl |
| $SO_2$ | Ethyl | Ethyl | Methyl | Methyl |
| SO | Methyl | Methyl | Methyl | Methyl |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |
| $NCH_3$ | Methyl | Methyl | Ethyl | Ethyl |
| $NCH_3$ | Methyl | Methyl | Methyl | Methyl |
| CONH | Methyl | Methyl | - | - |
| NH | Ethyl | Methyl | Ethyl | Methyl |
| NH | Methyl | Methyl | Methyl | Methyl |
| Si(Methyl)$_2$ | Methyl | Methyl | H | H |
| Si(Phenyl)$_2$ | Methyl | Methyl | Methyl | Methyl |
| Si(OMethyl)$_2$ | Ethyl | Ethyl | H | H |
| Si(OPhenyl)$_2$ | Methyl | Methyl | Methyl | Methyl |
| -OSi(Methyl)$_2$O- | Methyl | Methyl | Methyl | Methyl |
| Ethylen | Methyl | Methyl | H | H |
| Ethylen | Methyl | Methyl | Methyl | Methyl |
| Ethylen | Ethyl | Ethyl | H | H |
| Ethylen | Methyl | Methyl | Ethyl | Ethyl |
| Phenylen | Methyl | Methyl | Methyl | Methyl |
| Phenylen | Ethyl | Ethyl | H | H |
| $(CH_3)_2C<$ | Methyl | Ethyl | Methyl | Ethyl |
| $(CH_3)_2C<$ | Methyl | Methyl | Methyl | Methyl |
| $(CF_3)_2C<$ | Methyl | Methyl | Methyl | Methyl |
| direkte Bindung | Methyl | Methyl | H | H |
| direkte Bindung | Methyl | Ethyl | Methyl | Ethyl |
| direkte Bindung | Methyl | Ethyl | Methyl | H |

| E | A | B | C | D |
|---|---|---|---|---|
| direkte Bindung | Ethyl | Ethyl | Ethyl | Ethyl |
| direkte Bindung | Methoxy | Methoxy | Methoxy | Methoxy |
| direkte Bindung | Isopropyl | Isopropyl | H | H |
| direkte Bindung | Methoxy-methyl | Methoxy-methyl | Methoxy-methyl | Methoxy-methyl |

Die Diamine, von denen sich X ableitet, sind bekannt oder nach bekannten Verfahren herstellbar. Si-haltige Diamine sind in der US-PS 3,435,002 und der EP-A 0 054 426 beschrieben. Diamine mit der

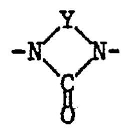

Gruppe können aus den in der DE-A-2 318 170 beschriebenen Diisocyanaten hergestellt werden. Alkyl-oder Cycloalkyl substituierte, besonders Ethyl oder Propyl substituierte Diamine sind durch Alkylierungen von unsubstituierten oder teilsubstituierten aromatischen Diaminen mit Alkenen bzw. Cycloalkenen zugänglich (vgl. US-PS 3 275 690). Mehrkernige, besonders zweikernige aromatische Diamine sind über die Kondensation entsprechender Monoamine mit Aldehyden oder Ketonen erhältlich.

X" im Strukturelement der Formel III kann lineares oder verzweigtes Alkylen mit 7 bis 30 C-Atomen, Cycloalkylen mit 5 bis 8 Ringkohlenstoffatomen, Aralkylen mit 7 bis 30 C-Atomen, Arylen mit 6 bis 22 C-Atomen und/oder ein Polysiloxanrest sein.

X" in Formel III in der Bedeutung als zweiwertiger aliphatischer Rest enthält bevorzugt 6 bis 30 und insbesondere 6 bis 20 C-Atome. In einer bevorzugten Untergruppe ist X" lineares oder verzweigtes Alkylen, das durch Sauerstoffatome, NH, NR°, $^{\oplus}NR_2°G^{\ominus}$ , Cyclopentylen, Naphtylen, Phenylen oder Hydantoinreste unterbrochen sein kann. R° kann z.B. Alkyl mit 1 bis 12 C-Atomen oder Cycloalkyl mit 5 oder 6 Ring-C-Atomen, Phenyl oder Benzyl sein. $G^{\ominus}$ bedeutet ein Anion einer Protonensäure, z.B. Halogenid, Sulfat, Phosphat. In einer bevorzugten Ausführungsform ist X" lineares oder verzweigtes Alkylen mit 6 bis 30 C-Atomen, $-(CH_2)_m-R^{13}-(CH_2)_n-$, worin $R^{13}$ Phenylen, Naphthylen, Cyclopentylen oder Cyclohexylen und m und n unabhängig voneinander die Zahl 1, 2 oder 3 sind, $-R^{14}-(OR^{15})_p-O-R^{14}-$, worin $R^{14}$ Ethylen, 1,2-Propylen, 1,3-Propylen oder 2-Methyl-1,3-propylen und $R^{15}$ Ethylen, 1,2-Propylen, 1,2-Butylen, 1,3-Propylen oder 1,4-Butylen und p eine Zahl von 1 bis 100 sind, oder

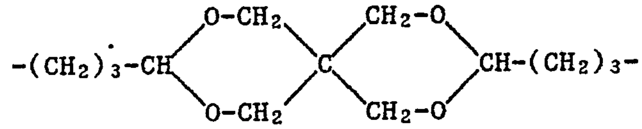 .

Beispiele für aliphatische Reste sind: Methylen, Ethylen, 1,2-oder 1,3-Propylen, 2,2-Dimethyl-1,3-propylen, 1,2-, 1,2-oder 1,4-Butylen, 1;3-oder 1,5-Pentylen, Hexylene, Heptylene, Octylene, Decylene, Dodecylene, Tetradecylene, Hexadecylene, Octadecylene, Eicosylene, 2,4,4-Trimethylhexylen, 1,10-Dialkyldecylen, wobei das Alkyl bevorzugt 1 bis 6 C-Atome aufweist, substituierte 1,11-Undecylene, wie sie z.B. in der EP-B-O 011 559 beschrieben sind, Reste von Jeffaminen wie z.B.

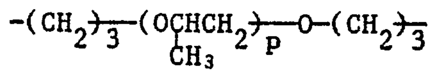 mit p = 1 bis 100 oder

$-(CH_2)_3-(O(CH_2)_4)_p-O-(CH_2)_3-$ mit p = 1-100, Dimethylencyclohexan

Xylylen und Diäthylenbenzol.

Bei den durch heterocyclische Reste unterbrochenen aliphatischen Resten kann es sich z.B. um solche handeln, die sich von N,N'-amino-alkylierten Hydantoinen oder Benzimidazolen ableiten. Beispiele sind N,N'-(γ-Aminopropyl)-5,5-dimethylhydantoin oder -benzimidazolon und solche der Formel

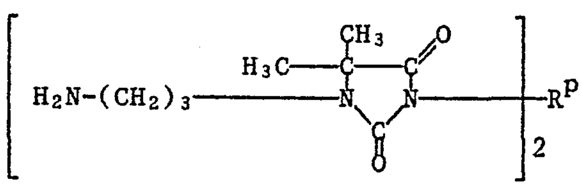

worin $R^p$ Alkylen mit 1 bis 12 bevorzugt 1 bis 4 C-Atomen oder

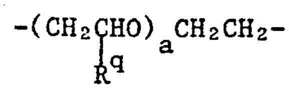

ist, worin $R^q$ ein Wasserstoffatom oder Methyl und a ganze Zahlen von 1-20 bedeuten.

Geeingnete Substituenten für die aliphatischen Reste sind z.B. Halogene wie F oder Cl oder Alkoxy mit 1 bis 6 C-Atomen.

X" in Formel III in seiner Bedeutung als zweiwertiger cycloaliphatischer Rest enthält bevorzugt 5 bis 8 Ring-C-Atome und ist besonders unsubstituiertes, oder mit Alkyl, das vorzugsweise 1 bis 4 C-Atome enthält, substituiertes ein-oder zweikerniges Cycloalkylen mit 5 bis 7 Ring-C-Atomen. In einer bevorzugten Ausführungsform ist X" als cycloaliphatischer Rest ein solcher der Formeln

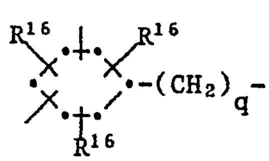

oder

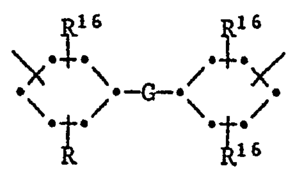

worin q 0 oder 1 ist, die $R^{16}$ unabhängig Wasserstoff oder Alkyl mit 1 bis 6 C-Atomen bedeuten und G für eine direkte Bindung, O, S, $SO_2$, Alkylen mit 1 bis 3 C-Atomen oder Alkyliden mit 2 bis 6 C-Atomen steht. $R^{16}$ ist bevorzugt Ethyl und Methyl, G bevorzugt Methylen und das Alkyliden enthält bevozugt 2 oder 3 C-Atome, wie Ethyliden und 1,1-oder 2,2-Propyliden.

Beispiele für X" als Cycloalkylen sind: 1,2-oder 1,3-Cyclopentylen, 1,2-, 1,3-oder 1,4-Cyclohexylen, Cycloheptylen, Cyclooctylen, Methylcyclopentylen, Methyl-oder Dimethylcyclohexylen, 3-oder 4-Methylcyclohex-1-yl, 5-Methyl-3-methylencyclohex-1-yl, 3,3'-oder 4,4'-Bis-cyclohexylen, 3,3'-Dimethyl-4,4'-biscyclohexylen, 4,4'-Biscyclohexylenäther oder -sulfon oder -methan oder -2,2-propan, sowie die Reste von Bis-aminomethyltricyclodecan, Bisaminomethylnorbornan und Menthandiamin.

Besonders bevorzugt ist X" als cycloaliphatischer Rest 1,4-oder 1,3-Cyclohexylen, 2,2,6-Trimethyl-6-methylen-cyclohex-4-yl, Methylenbis-(cyclohex-4-yl) oder Methylenbis(3-methylcyclohex-4-yl).

X" als araliphatischer Rest enthält bevorzugt 7 bis 30 C-Atome. Die aromatischen Gruppen sind bevorzugt so substituiert wie X' als aromatischer Rest, einschliesslich der Bevorzugungen, zumindest aber monosubstituiert, bevorzugt in Orthostellung zum N-Atom. Der araliphatische Rest enthält besonders 8 bis 26 C-Atome. Der aromatische Rest im araliphatischen Rest ist bevorzugt ein Phenylrest. In seiner Bedeutung als araliphatischer Rest ist X" besonders unsubstituiertes oder am Aryl durch Alkyl substituiertes Aralkylen, wobei der Alkylenrest linear oder verzweigt ist. In einer bevorzugten Ausführungsform entspricht der araliphatische Rest der Formel

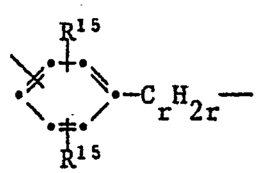

worin die $R^{15}$ unabhängig voneinander ein Wasserstoffatom oder besonders Alkyl mit 1-6 C-Atomen und r ganze Zahlen von 1-20 bedeuten.

Die freie Bindung befindet sich bevorzugt in m-Stellung oder p-Stellung zur $C_r H_{2r}$ -Gruppe und eine beide R $^{15}$ sind bevorzugt in o-Stellung zur freien Bindung gebunden.

Beispiele für X" als araliphatischer Rest sind; m-oder p-Benzylen, 3-Methyl-p-benzylen, 3-Ethyl-p-benzylen, 3,5-Dimethyl-p-benzylen, 3,5-Diethyl-p-benzylen, 3-Methyl-5-ethyl-p-benzylen, p-Phenylenpropylen, 3-Methyl-p-phenylen-propylen, p-Phenylenbutylen, 3-Ethyl-p-phenylenpentylen sowie insbesondere längerkettige Phenylenalkylenreste, die z.B. in der EP-A-O 069 062 beschrieben sind: 6-(p-Phenylen)-6-methylhept-2-yl, 6-(3'-Methyl-p-phenylen)-6-methylhept-2-yl, 6-3'-Ethyl-p-phenylen)-6-methylhept-2-yl, 6-(3',5'-Dimethyl-p-phenylen)-6-methylhept-2-yl, 11-(p-Phenylen)-2,11-dimethyl-dodec-1-yl, 13-(p-Phenylen)-2,12-dimethyltetradec-3-yl.

X" als Arylen enthält bevorzugt 6 bis 22 C-Atome. Das Arylen ist besonders ein ein-oder zweikerniger Phenylenrest. Das Arylen kann substituiert sein, z.B. durch Alykyl oder Alkoxy mit 1 bis 6 C-Atomen, Alkoxymethyl mit 2 bis 6 C-Atomen und/oder Halogen wie F oder Cl.

Bevorzugt sind 1,3-Phenylene, die in einer Orthostellung zur freien Bindung durch Alkyl mit 1 bis 4 C-Atomen, besonders Methyl, substituiert sind.

In einer Ausführungsform entspricht X" der Formel IX,

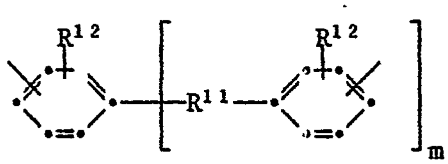

(IX)

worin m 0 oder 1 ist, die freien Bindungen in Meta- und bevorzugt in Orthostellung zur $R^{12}$-Gruppe gebunden sind, $R^{11}$ die gleiche Bedeutung wie in Formel VIIIa hat und $R^{12}$ die gleiche Bedeutung wie $R^5$hat.

Eine bevorzugte Untergruppe sind Arylenreste der Formeln IXa, oder IXb oder IXc

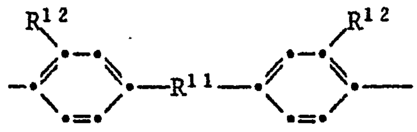

(IXa),

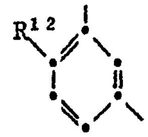

(IXb),

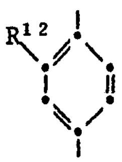

(IXc),

worin $R^{11}$ für eine direkte Bindung, -O-, -CO-oder -$CH_2$-steht und $R^{12}$ Methyl, Ethyl, Isopropyl, Methoxy, Ethoxy oder ein Wasserstoffatom bedeutet.

Beispiele für Diamine $H_2N$-X"-$NH_2$ mit einem aromatischen Rest sind:

4,4'-Methylenbis-(o-chloranilin), 3,3'-Dichlorbenzidin, 3,3'-Sulfonyldianilin, 4,4'-Diaminobenzophenon, 1,5-Di-aminoaphthalin, Bis-(4-aminophenyl)-dimethylsilan, Bis-(4-aminophenyl)-diäthylsilan, Bis-(4-aminophenyl)-diphenylsilan, Bis-(4-aminophenyloxy)-dimethylsilan, Bis-(4-aminophenyl)-äthyl-phosophinoxid, N-[Bis-(4-aminophenyl)]-N-methylamin, N-[Bis-(4-aminophenyl)-N-phenylamin, 4,4'-Methylenbis-(3-methylanilin), 4,4'-Methylen bis-(2-äthylanilin), 4,4'-Methylenbis-(2-methoxyanilin), 5,5'-Methylenbis-(2-aminophenol), 4,4'-Methylenbis-(2-methylanilin), 4,4'-Oxybis-(2-methoxyanilin), 4,4'-Oxybis-)-2-chloranilin), 5,5'-Oxybis-(2-aminophenol), 4,4'-Thiobis-(2-methylanilin), 4,4'-Thiobis-(2-methoxyanilin), 4,4'-Thiobis-(2-chloranilin), 4,4'-Sulfonylbis-(2-methylanilin), 4,4'-Sulfonylbis-(2-äthoxyanilin), 4,4'-Sulfonylbis-(2-chloranilin), 5,5'-Sulfonylbis-(2-aminophenol), 3,3'-Dimethyl-4,4'-diaminobenzophenon, 3,3'-Dimethoxy-4,4'-diaminobenzophenon, 3,3'-Dichlor-4,4'-diaminobenzophenon, 4,4'-Diaminobiphenyl, m-Phenylendiamin, p-Phenylendiamin, 4,4'-Methylendianilin, 4,4'-Oxydianilin, 4,4'-Thiodianilin, 4,4'-Sulfonyldianilin, 4,4'-Isopropylidendi anilin, 3,3'-Dimethylbenzidin, 3,3'-Dimethoxybenzidin, 3,3'-Dicarboxybenzidin, Diaminotoluol, 4,4'-Methylenbis-(3-carboxyanilin) und deren Ester, 5-Amino-1-(4-aminophenyl)-1,3,3-Trimethylindan.

X" kann auch ein Siloxangruppen enthaltender zweiwertiger Rst sein. Dieser kann Formel

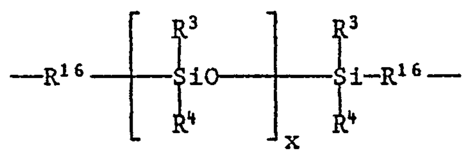

entsprechen, worin x für eine rationale Zahl von mindestens 1 steht, $R^3$ und $R^4$ die zuvor angegebene Bedeutung haben und $R^{16}$ ein zweiwertiger Kohlenwasserstoffrest ist, z.B. Alkylen mit 1 bis 12, vorzugsweise 1 bis 6 C-Atomen, Cycloalkylen mit bevorzugt 5 oder 6 Ringkohlenstoffatomen oder Phenylen. $R^3$ und $R^4$ sind bevorzugt Methyl oder Phenyl und x bevorzugt eine Zahl von 1 bis 1000, besonders 1 bis 100 und insbesondere 1-10. Beispiele für Alkylen sind Ethylen, 1,3-oder 1,2-Propylen, 1,3-oder 1,4-Butylen. Diamine mit dieser Gruppe X" sind in der US-PS 4 030 948 beschrieben. Weitere geeignete Diamine mit einer Siloxangruppe enthaltenden Gruppe X" sind in der US-PS 3 435 002 und EP-A-O 054 426 beschrieben.

Z und Z' enthalten als vierwertiger aromatischer Rest und Z"' als dreiwertiger Rest bevorzugt 6 bis 30, besonders 6 bis 20 C-Atome. In einer bevorzugten Untergruppe enspricht Z' den Formeln

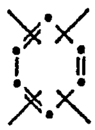, 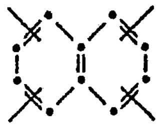, 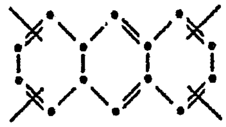, 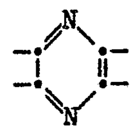, 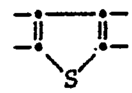,

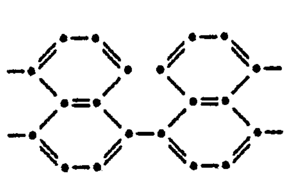, 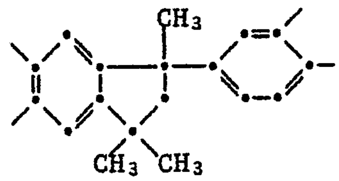, 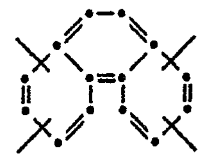,

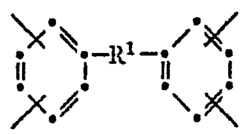

worin $R^1$ eine direkte Bindung oder eine Brückengruppe der Formeln

-O-, -S-, $-SO_2-$, 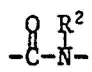, 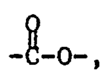, 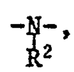, 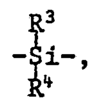, 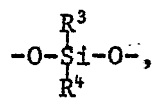, 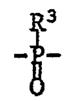,

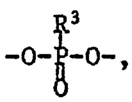, -N=N-, 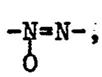, -NH-, 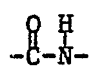, $-CH_2-$, $-CH_2CH_2-$, 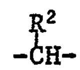,

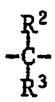, 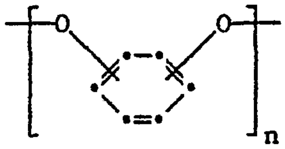, 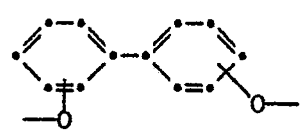

ist, worin $R^2$, $R^3$ und $R^4$ alkyl mit 1 bis 6 C-Atomen, Phenyl oder Benzyl und $R^3$ und $R^4$ in den Si enthaltenden Gruppen Alkoxy mit 1 bis 6 C-Atomen, Phenyloxy oder Benzyloxy sind.

In den vorausstehenden Formeln befinden sich stets je zwei der freien Bindungen in Peri-und/oder Orthostellung.

Eine bevorzugte Untergruppe für Z' sind Reste der Formeln

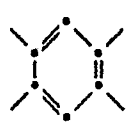 oder 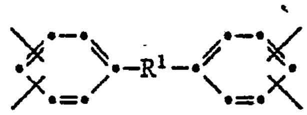

ist, worin $R^1$ eine direkte Bindung, -O-, $-SO_2-$oder $CH_2$ ist.

Ganz besonders bevorzugt ist Z' ein Rest der Formel

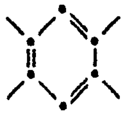

Beispiele für Tetracarbonsäureanhydride mit einem Rest Z' sind:

2,3,9,10-Perylentetracarbonsäuredianhydrid,

1,4,5,8-Naphthalintetracarbonsäuredianhydrid,

2,6-Dichlornaphthalin-1,4,5,8-tetracarbonsäuredianhydrid,

2,7-Dichlornaphthalin-1,4,5,8-tetracarbonsäuredianhydrid,

2,3,6,7-Tetrachlornaphthalin-1,4,5,8-tetracarbonsäuredianhydrid,

Phenanthren-1,8,9,10-tetracarbonsäuredianhydrid,

Pyromellitsäuredianhydrid,

3,3',4,4'-Biphenyltetracarbonsäuredianhydrid,

2,2',3,3'-Biphenyltetracarbonsäuredianhydrid,

4,4'-Isopropylidendiphthalsäureanhydrid,

3,3'-Isopropylidendiphthalsäureanhydrid,

4,4'-Oxydiphthalsäureanhydrid,

4,4'-Sulfonyldiphthalsäureanhydrid,

3,3'-Oxydiphthalsäureanhydrid,

4,4'-Methylendiphthalsäureanhydrid,

4,4'-Thiodiphthalsäureanhydrid,

4,4'-Ethylidendiphthalsäureanhydrid,

2,3,6,7-Naphthalintetracarbonsäuredianhydrid,

1,2,4,5-Naphthalintetracarbonsäuredianhydrid,

1,2,5,6-Naphthalintetracarbonsäuredianhydrid,

Benzol-1,2,3,4-tetracarbonsäuredianhydrid,

Thiophen-2,3,4,5-tetracarbonsäuredianhydrid,

1-(3',4'-Dicarboxyphenyl)-1,3,3-trimethylindan-5,6-dicarbonsäuredianhydrid,

1-(3',4'-Dicarboxyphenyl)-1,3,3-trimethylindan-6,7-dicarbonsäuredianhydrid,

1-(3',4'-Dicarboxyphenyl)-3-methylindan-5,6-dicarbonsäuredianhydrid,

1-(3',4'-Dicarboxyphenyl)-3-methylindan-6,7-dicarbonsäuredianhydrid.

Z in Formel I entspricht bevorzugt den Formeln V, VI, VII oder VIII

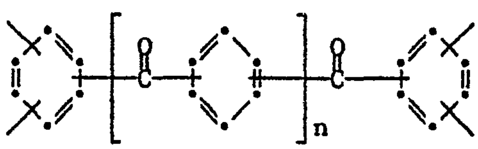 (V) ,

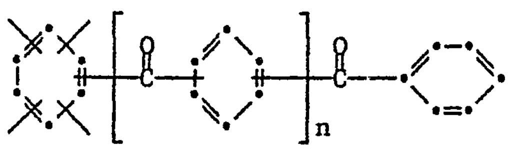 (VI) ,

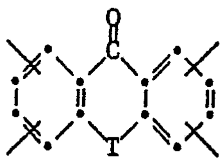 (VII) ,

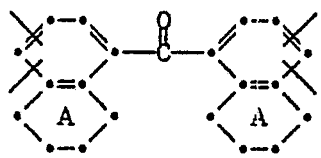 (XI) ,

worin n o oder 1 ist, T eine direkte Bindung, $-CH_2-$, -O-, -S-, -SO-, $-SO_2-$, -CO-, $NR^b$ oder $-CR^bR^c$-darstellt, worin $R^b$ für ein Wasserstoffatom, $C_1$-$C_{10}$-Alkyl, Napthyl oder Benzyl steht und R $^c$die Bedeutung von $R^b$ mit Ausnahme von Wasserstoff hat, die Ringe A in Formel XI gesättigt oder aromatisch sind, und je zwei freie Bindungen in Orthostellung zueinander gebunden sind.

In den Formel V und VI ist n bevorzugt O. T in Formel VII steht bevorzugt für -O-oder -CO-.

Z''' ist bevorzugt ein dreiwertiger Phenyl-, Naphtyl oder Biphenylenrest. Bevorzugt entspricht Z''' den Formeln

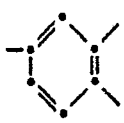 , 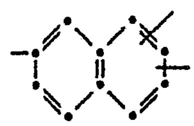 oder 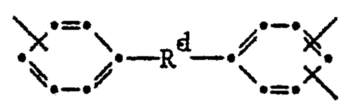 ,

worin $R^d$ eine Brückengruppe oder eine direkte Bindung darstellt und zwei freie Bindungen in Orthostellung zueinander stehen. $R^d$ ist als Brückengruppe bevorzugt -O-, -S-, -CO-, und $-CH_2-$ sowie Alkyliden mit 2 bis 6 C-Atomen, Cyclopentyliden und Cyclohexyliden.

Der aromatische Rest X' in Formel II ist bevorzugt in mindestens einer, besonders in beiden Orthostellungen zur freien Bindung durch Alkyl oder Aralkyl substituiert. Der Substituent ist als Aralkyl besonders Benzyl. Als Alkyl enthält der Substituent bevorzugt 1 bis 12, besonders 1 bis 4 C-Atome. Das Alkyl kann linear oder verzweigt sein. Besonders bevorzugt sind Methyl, Ethyl und Isopropyl. Weitere Beispiele sind n-Propyl, n-Butyl, Isobutyl, Pentyl, Hexyl, Octyl, Decyl und Dodecyl.

Der aromatische Rest X' ist bevorzugt ein durch Alkyl substituierter Phenylenrest oder Bisphenylenrest. Insbesondere entspricht der Rest X' der Formel X

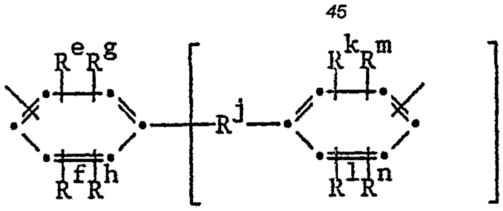 q' (X)

worin q' 0 oder 1 ist, $R^j$ eine direkte Bindung oder eine Brückengruppe bedeutet, $R^e$ Alkyl mit 1 bis 4 C-Atomen und $R^f$ bis $R^n$ ein Wasserstoffatom oder Alkyl mit 1 bis 4 C-Atomen sind, und die freien Bindungen in Meta-oder Parastellung zur $R^j$-Gruppe gebunden sind.

In einer Ausführungsform sind $R^e$ und $R^f$ sowie $R^m$ und $R^n$ in Orthostellung zur freien Bindung gebunden und bedeuten $C_1$-$C_4$-Alkyl. In einer besonders bevorzugten Ausführungsform steht q' in Formel II für O und $R^e$ bis $R^h$ für $C_1$-$C_4$-Alkyl, besonders Methyl oder Ethyl.

Die Brückengruppe $R^j$ kann die gleiche Bedeutung wie $R^{11}$ haben. Bevorzugt ist $R^j$ eine direkte Bindung, -S-, -O-, -SO-, -$SO_2$-, -CO-$CH_2$ oder $C_2$-$C_6$-Alkyliden, wie z.B. Ethyliden, 1,1-oder 2,2-Propyliden, Butyliden, Cyclopentyliden und Cyclohexyliden.

In einer besonderen Ausführungsform entspricht der Rest der Formel II dem Strukturelement der Formel

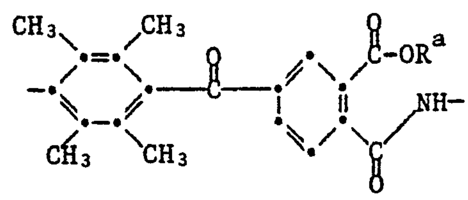

Die Polyamidsäuren-und -arylester und t-ammoniumsalze weisen mittlere Molekulargewichte -(Gewichtsmittel $\overline{M}w$) von bevorzugt mindestens 2 000, vorzugsweise mindestens 5 000 auf. Die obere Grenze richtet sich im wesentlichen nach Eigenschaften, die die Verarbeitbarkeit bestimmen, wie z.B. deren Löslichkeit und Lichtempfindlichkeit. Sie kann bis zu 500 000, vorzugsweise bis zu 100 000 und besonders bis zu 60 000 betragen. Es kann sich ferner um statistische Polymere oder um Blockpolymere handeln. Sie werden nach üblichen Verfahren in hierfür vorgesehenen Einrichtungen hergestellt.

Die Aminodicarbonsäuren mit Strukturelementen der Formel II sind z.B. auf folgende Weise erhältlich:

Trimellitsäure-n-butylimid wird mit $SOCl_2$ in

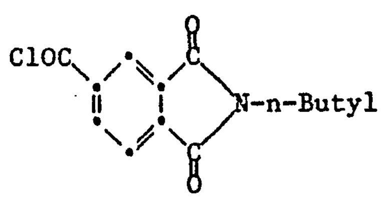

überführt und in Gegenwart von $AlCl_3$ mit

HX'H

zu

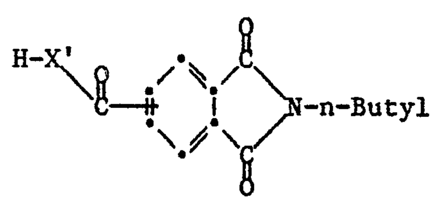

umgesetzt. Diese Verbindung wird mit $NHO_3$ nitriert und die gebildete Nitroverbindung katalytisch zur Aminoverbindung

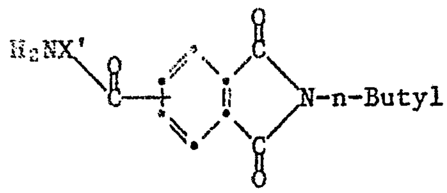

hydriert. Das Imid kann in bekannter Weise in seine Säurederivate umgewandelt werden.

4,4'-Ketobis-)naphthalin-1,2-dicarbonsäure) ist durch die Umsetzung von 2 Mol 1,2-Dimethylnaphthalin mit $COCl_2$ in Gegenwart von $AlCl_3$ und die anschliessende Oxidation des gebildeten 4,4'-Ketobis(1,2-dimethylnaphthalins) mit $HNO_3$ zur Tetracarbonsäure erhältlich. Diese Tetracarbonsäure kann partiell zur 4,4'-Keto-(tetrahydronaphthalin-1,2-dicarbonsäure) hydriert werden. Die Hydrierung kann auch vor der Oxidation mit 4,4'-Ketobis(1,2-dimethyl)naphthalin vorgenommen werden.

Tetracarbonsäuren mit Strukturelementen der Formel VIII sind teilweise bekannt.

Antrachinontetracarbonsäuren sind z.B. im US-Patent 3 702 318 und CA 100,1006119a (1984) beschrieben.

Durch Hydrierung der Ketogruppen in Anthrachinontetracarbonsäuren mit z.B. $NaBH_4$ erhält man die entsprechende Dihydroxyverbindung, die durch Behandlung mit Salzsäure mit Rückfluss in Anthrontetracarbonsäure überführt werden kann. Die $CH_2$-Gruppe der Anthrontetracarbonsäure kann in bekannter Weise alkyliert und so in die $CHR^b$-bzw. $CR^bR^c$-Gruppe überführt werden.

Zur Herstellung von Fluorenontetracarbonsäure kann man z.B. 3,4-Dimethylmagnesiumbromid in Gegenwart von $CuCl_2$ dimerisieren und das gebildete 3,3',4,4'-Tetramethylbiphenyl mit $COCl_2$ in Gegenwart von $AlCl_3$ zum Tetramethylfluorenon umsetzen, das in bekannter Weise mit z.B. $NHO_3$ zur Tetracarbonsäure oxidiert werden kann.

Xanthontetracarbonsäure erhält man, indem man zunächst 3,3',4,4'-Tetramethylphenylether mit $CCl_4$ in Gegenwart von $AlCl_3$ und anschliessender Hydrolyse mit verdünnter HCl zu 2,3,6,7-Tetramethylxanthon umsetzt, das in üblicher Weise zur Tetracarbonsäure oxidiert wird, z.B. mit $NHO_3$.

Tetracarbonsäuren mit Strukturelementen der Formel VII, woring T S, SO, $SO_2$ oder $NR^b$ bedeutet, sind auf folgendem Weg erhältlich: 1-Brom-3,4-dimethylbenzol wird mit $CCl_4$ in Gegenwart von $AlCl_3$ zum Bis-(2-Brom-3,4-dimethylphenyl)-dichlormethan umgesetzt.

Die Oxidation mit 20%-iger $HNO_3$ führt zu

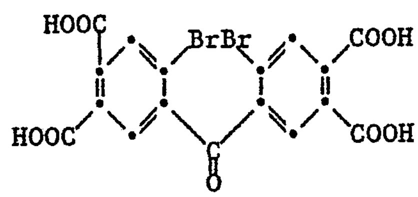

Die Umsetzung mit $Na_2S$ ergibt die Thioxanthontetracarbonsäure, die in bekannter Weise zum Sulfoxid bzw. Sulfon oxidiert werden kann. Die Umsetzung mit $NaNH_2$ oder $R^bNH_2$ führt zu den Acridontetracarbonsäuren.

Die Herstellung von Polyamidsäuren aus Tetracarbonsäuren und Diaminen als Zwischenstufen für Polyimide ist allgemein bekannt. Die Reaktion wird vorteilhaft in Lösung durchgeführt und die Reaktionstemperaturen können -20 bis 300°C betragen.

Die t-Ammoniumsalze werden erhalten, indem man in den Polyamidsäuren die Carboxylgruppen mit bis zu äquimolaren Mengen eines tertiären Amins umsetzt.

Die Polyamidsäurearylester sind erhältlich, indem man Anhydride zu Arylestern umsetzt, danach die Carbonsäuregruppe chloriert und darauf mit einem Diamin umsetzt. Die teilweise Alkylierung mit z.B. Dimethylsulfat ergibt Abmischungen mit Polyamidsäuremethylestern. Durch Umesterung mit anderen Alkoholen können andere aliphatische Gruppen eingeführt werden.

Die Polyamidsäuren bzw. -arylester bzw. t-ammoniumsalze können anschliessend nach üblichen Verfahren, z.B. durch Entfernen des Lösungsmittels oder Ausfällen durch Zugabe eines Nichtlösungsmittels, isoliert werden. Die Lösungen können auch direkt zur Beschichtung von Trägermaterialien verwendet werden.

Die Polyamidsäuren und -arylester -und -t-ammoniumsalze sind in unterschiedlichen Lösungsmitteln leicht löslich. Sie eignen sich hervorragend zur Hestellung von Filmen und Schutzüberzügen. Ein weiterer Gegenstand vorliegender Erfindung ist die Verwnedung des erfindungsgemässen Materials zur Herstellung von Schutzüberzügen und Filmen.

Zur Herstellung des erfindungsgemässen beschichteten Materials löst man das Polymer oder Gemische davon zweckmässig in einem geeigneten organischen Lösungsmittel, gegebenenfalls unter Erwärmung. Geeignete Lösungsmittel sind z.B. polare, aprotische Lösungsmittel, die alleine oder in Mischungen aus mindestens zwei Lösungsmitteln verwendet werden können. Beispiele sind: Ether wie Dibutylether, Tetrahydrofuran, Dioxan, Methylenglykol, Dimethylethylenglykol, Diemethyldiethylenglykol, Diethyldiethylenglykol, Dimethyltriethylenglykol, halogenierte Kohlenwasserstoffe wie Methylenchlorid, Chloroform, 1,2-Dichlorethan, 1,1,1-Trichlorethan, 1,1,2,2-Tetrachlorethan, Carbonsäureester und Lactone wie Essigsäureethylester, Propionsäuremethylester, Benzoesäureethylester, 2-Methoxyethylacetat, $\gamma$-Butyrolacton, o-Valerolacton und Pivalolacton, Carbonsäureamide und Lactame wie Formamid, Acetamid, N-Methylformamid, N,N-Dimethylformamid, N,N-Diethylformamid, N,N-Dimethylacetamid, N,N-Diethylacetamid, $\gamma$-Butyrolactam, $\epsilon$-Caprolactam, N-Methyl pyrrolidon, N-Acetylpyrrolidon, N-Methylcaprolactam, Tetramethylharnstoff, Hexamethylphosphorsäuretriamid, Sulfoxide wie Dimethylsulfoxid, Sulfone wie Diethylsulfon, Diethylsulfon, Trimethylensulfon, Tetramethylensulfon, Trimethylamin, Triethylamin, N-Methylpyrrolidin, N-Methylpiperidin, N-Methylmorpholin, substituierte Benzole wie Chlorbenzol, Nitrobenzol, Phenole oder Kresole.

Ungelöste Anteile können durch Filtration, bevorzugt einer Druckfiltration entfernt werden. Die Konzentration an Polymer im so erhaltenen Beschichtungsmittel beträgt vorzugweise nicht mehr als 50 Gew.-%, besonders nicht mehr als 30 Gew.-% und insbesondere nicht mehr als 20 Gew.-%, bezogen auf die Lösung.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Antioxidantien, Lichtschutzmittel, Stabilisatoren, Farbstoffe, Pigmente und Haftvermittler und Antihalofarbstoffe, wie z.B. in der US-PS 4 349 619 sind. Zur Erhöhung der Lichtempfindlichkeit können auch Sensibilisatoren einverleibt werden.

Das Beschichtungsmittel kann mittels üblichen Methoden wie Tauch-, Streich-und Sprühverfahren, Schleuder-, Kaskadenguss-und Vorhang-gussbeschichtung, auf geeignete Substrate bzw. Trägermaterialien, aufgebracht werden. Geeignete Substrate sind z.B. Kunststoffe, Metalle und Metallegierungen, Halbmetalle, Halbleiter, Glas, Keramik und andere anorganische Materialien wie z.B. $SiO_2$ und $Si_3N_4$. Danach wird das Lösungsmittel gegebenenfalls durch Erwärmen und gegebenenfalls im Vakuum entfernt. Man erhält klebfreie, trockene und gelichmässige Filme. Die aufgebrachten Filme können je nach Anwendung Schichtdicken bis zu ca. 500 µm und mehr, bevorzugt von 0,5 bis 500 µm und besonders von 1 bis 50 µm aufweisen.

Es wurde gefunden, dass die erfindungsgemässen Polyamidsäuren-bzw. arylester-bzw. -t-ammoniumsalze autophotovernetzbar sind und unter Strahlungseinwirkung vernetzt werden können. Da die Lichtempfindlichkeit mit steigendem Gehalt an solchen Strukturelementen steigt, ist ein Gehalt von mindestens 90 Mol-% Strukturelementen der Formeln I und II vorteilhaft.

Aus dem erfindungsgemässen Material können durch Strahlungsein-wirkung Schutzfilme hergestellt werden. Ferner besteht die Möglichkeit, das Material als photographisches Aufzeichnungsmaterial für Reliefabbildungen einzusetzen. Durch die Direktvernetzung unter Strahlungseinwirkung können Zusätze wie Sensibilisatoren vermieden werden und die Schutzschichten und Abbildungen weisen ausgezeichnete elektrische Eigenschaften auf. Nach der Bestrahlung kann durch eine thermische Behandlung bei vorzugsweise 150 bis 450°C, besonders 200 bis 400°C, die Polyamidsäure bzw. der Polyamidsäurearylester bzw. das Polyamidsäure-t-ammoniumsalz in das entsprechende Polyimid überführt werden, wodurch man die vorteilhaften Eigenschaften der Polyimide erzielt. Solche Schutzschichten und Abbildungen zeichnen sich durch ihre hohe Thermostabilität aus. Die Schichtdicke für photographische Reliefabbildungen beträgt bevorzugt 0,5 bis 100 µm, besonders 1 bis 50 µm und insbesondere 1-10 µm.

Die Phtostrukturierung bzw. Photovernetzung kann durch energiereiche Strahlung hervorgerufen werden, z.B. durch Licht insbesondere im UV-Bereich, durch Röntgenstrahlen, Laserlicht, Elektronenstrahlen usw. Das erfindungsgemässe Material

eignet sich hervorragend zur Herstellung von Schutzfilmen, Passivierlacken, und als photographisches Aufzeichnungsmaterial für thermostabile Reliefabbildungen.

Anwendungsgebiete sind z.B. Schutz-, Isolier- und Passivierlacke in der Elektrotechnik und Elektronik, Photomasken für die Elektronik, den Textildruck und das graphische Gewerbe, Aetzresisit zur Herstellung gedruckter Schaltungen und Druckplatten und integrierter Schaltkreise, Relais für die Herstellung von Röntgenmasken, als Lötstopplack, als Dielektrikum für Mehrlagenschaltungen, als Strukturelement für Flüssigkristallanzeiger.

Die Herstellung von Schutzfilmen erfolgt durch direktes Belichten, wobei sich die Belichtungszeiten im wesentlichen nach den Schichtdicken und der Lichtempfindlichkeit richten. Nach der Bestrahlung kann durch thermische Behandlung das Polyimid erhalten werden.

Die photographische Erzeugung der Reliefstruktur erfolgt durch bildmässige Belichtung durch eiene Photomaske, anschliessende Entwicklung unter Entfernung der unbelichteten Anteile mit einem Lösungsmittel oder einem Lösungsmittelgemisch, wonach gegebenenfalls das erzeugte Bild durch eine thermische Nachbehandlung stabilisiert werden kann, wobei sich die entsprechenden Polyimide bilden.

Ein weiterer Gegenstand der Erfindung ist ein solches Verfahren zum Aufbringen von Reliefstrukturen und zur Herstellung von Schutzschichten. Als Entwickler sind z.B. die zuvor erwähnten Lösungsmittel geeignet.

Die Polymerschicht des erfindungsgemässen Materials weist eine für viele Anwendungszwecke ausreichende und teilweise hohe Lichtempfindlichkeit auf und sie kann direkt photovernetzt werden. Die Schutzfilme und Reliefabbildungen zeichnen sich durch gute Haftfestigkeit und nach der thermischen Behandlung durch thermische, mechanische und chemische Widerstandsfähigkeit aus. Das Material ist lagerstabil, aber vorteilhaft vor Lichteinwirkung zu schützen.

Die nachfolgenden Beispiele erläutern die Erfindung näher.

A. Herstellungsbeispiele

Beispiel 1: In einem zylindrischen Gefäss werden 1,642 g (0,01 Mol) 3,6-Diaminodurol in 20 ml N-Methylpyrrolidon (NMP) gelöst und unter Rühren und Inertgas allmählich 3,22 g (0,01 Mol) Benzophenontetracarbonsäuredianhydrid (BDTA) zugesetzt.

Nach 4 Stunden Rühren wird die Polyamidsäurelösung mit weiterem NMP verdünt und die Lösung direkt weiterverwendet.

Beispiele 2 bis 6: Gemäss Beispiel 1 werden verschiedene Diamine mit BDTA zu Polyamidsäuren umgesetzt. Die Polyamidsäurelösung von Beispiel 5 wird zur Herstellung von t-Ammoniumsalzen mit 2 Mol pro Grundmol Polyamidsäure Trimethylamin (5a) Ethyldiisopropylamin (5b), Benzyldimethylamin (5c) und N,N-Dimethylanilin (5d) versetzt.

| Beispiel | Diamin |
|---|---|
| 2 | 2,4-Diamino-3,5-diethyltoluol |
| 3 | 3,3',5,5'-Tetramethyl-4,4'-diaminodiphenylmethan |
| 4 | 3,3',5,5'-Tetraethyl-4,4'-diaminodiphenylmethan |
| 5 | 3,3'-Dimethyl-5,5'-diäthyl-4,4'-diaminodiphenylmethan |
| 5a | Trimethylammoniumsalz der Polyamisäure von Beispiel 5 |
| 5b | Ethyldiisopropylammoniumsalz der Polyamidsäure von Beispiel 5 |
| 5c | Benzyldimethylammoniumsalz der Polyamidsäure von Beispiel 5 |
| 5d | Dimethylphenylammoniumsalz der Polyamidsäure von Beispiel 5 |
| 6 | 3,3',5,5'-Tetramethyl-4,4'-diaminodiphenyl. |

Beispiel 7: Gemäss Beispiel 1 wird eine Polyamidsäure aus stöchiometrischen Mengen 3,3',5,5'-Tetramethyl-4,4'-diaminodiphenylmethan und Anthrachinon-2,3,6,7-tetracarbonsäuredianhydrid in NMP hergestellt, mit dem Unterschied, dass die Reaktionszeit auf 20 Stunden ausgedehnt wird.

B) Anwendungsbeispiele

Beispiel 8:

Auf einer einseitig Kupfer-kaschierten Kunststoffplatte wird ein dünner Polymerfilm erzeugt, indem eine 5%-ige Polymerlösung aufgeschleudert wird und das Lösungsmittel anschliessend in einem Umluftofen entfernt wird. Als Lösungsmittel wird N-Methylpyrrolidon oder DMF verwendet.

Die so beschichteten Platten werden durch eine Photomaske bei Raumtemperatur mit einer 1 000 Watt-UV-Lampe aus 18 cm Entfernung belichet. Die belichteten Platten werden anschliessend mit einem Lösungsmittel entwickelt, wobei die unbelichteten Anteile des Polymerfilms weggelöst werden. Die Sichtbarmachung des Reliefbildes geschieht anschliessend durch Wegätzen der freigelegten Kupferschicht mit $FeCl_3$-Lösung.

In der folgenden Zusammenstellung sind die Belichtungszeiten zur Erzeugung einer vollständigen Abbildung für die Polymeren aus den Beispielen 1 bis 7 wiedergegeben.

| Beispiel | 1 | 2 | 3 | 4 | 5 | 5a | 5b | 5c | 5d | 6 | 7 |
|---|---|---|---|---|---|---|---|---|---|---|---|
| Sekunden | 30 | 90 | 120 | 120 | 180 | 60 | 60 | 60 | 60 | 180 | 120 |

Durch Erhitzen auf 300°C bis 400°C werden die Abbildungen aus Polyamidsäuren zu den entsprechenden Polyimiden cyclisiert.

**Ansprüche**

1. Beschichtetes Material, bei dem auf mindestens einer Oberfläche eines Trägermaterials eine Schicht einer Polyamidsäure, eines Polyamidsäurearylesters, eines Polyamidsäureaminsalzes oder Mischungen hiervon aufgebracht ist, die 50 bis 100 Mol-%, bezogen auf das Polymer, mindestens eines Strukturelementes der Formeln I oder II oder Mischungen hiervon,

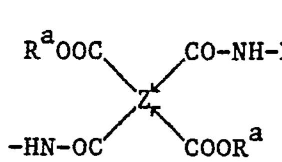 (I) ,

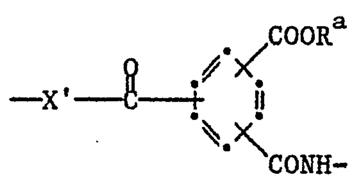 (II)

und

0 bis 50 Mol-% mindestens eines Strukturelementes der Formeln III oder IV oder Mischungen hiervon,

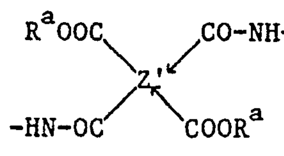 (III) ,

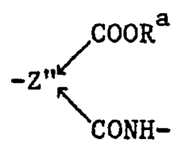 (IV),

enthalten, worin die Pfeile Stellungsisomerie bedeuten, $R^a$ ein Wasserstoffatom, Aryl, tertiäres Ammonium mit mindestens einem aliphatischen oder araliphatischen Kohlenwasserstoffrest ist, oder Mìschungen hiervon,

Z einen vierwertigen aromatischen Rest darstellt, der ein Benzophenonstrukturelement enthält, an den je eine -CONH-und $COOR^a$ -Gruppe an einen oder zwei verschiedenen Phenylresten in Orthostellung oder Peristellung zueinander gebunden sind,

Z' für einen vierwertigen, von Z verschiedenen aromatischen Rest steht, and den je eine Ester-und Amidgruppe in Ortho-oder Peristellung zueinander gebunden sind

Z" einen dreiwertigen aromatischen Rest bedeutet, der vom Rest im Strukturelement der Formel II verschieden ist, und an den je eine Ester-und Amidgruppe in Ortho-oder Persitellung zueinander gebunden sind,

X den Rest eines aromatischen Diamines bedeutet, der in beiden Orthostellungen zu mindestens einem N-Atom durch Alkyl, Cycloaklyl, Alkoxy, Alkoxyalkyl oder Aralkyl substituiert ist, oder zwei benachbarte C-Atome des aromatischen Restes durch Alkylen substituiert sind,

X' ein zweiwertiger aromatischer Rest ist, der durch mindestens eine wie für X definierte Gruppe substituiert ist, und

X" die gleiche Bedeutung wie X hat oder einen von X verschiedenen zweiwertigen Rest eines organischen Diamines darstellt.

2. Material gemäss Anspruch 1, dadurch gekennzeichnet, das X und X' als aromatischer Rest einen zweiwertigen, ein-oder zweikernigen Phenylenrest darstellen.

3. Material gemäss Anspruch 1, dadurch gekennzeichnet, dass $R^a$Phenyl und besonders ein Wasserstoffatom oder tertiäres Ammonium mit mindestens einem aliphatischen oder araliphatischen Kohlenwasserstoffrest ist.

4. Material gemäss Anspruch 1, dadurch gekennzeichnet, dass der Substituent von X und X' als Alkyl oder Alkoxy 1 bis 20 C-Atome, als Alkoxyalkyl 2 bis 12 C-Atome, als Cycloaklkyl 5 oder 6 Ringkohlenstoffatome, und als Alkylen 3 oder 4 C-Atome enthält und als Aralkyl Benzyl ist.

5. Material gemäss Anspruch 4, dadurch gekennzeichnet, dass der Substituent Alkyl mit 1 bis 4 C-Atomen, bevorzugt Isopropyl, Aethyl und besonders Methyl ist.

6. Material gemäss Anspruch 1 dadurch gekennzeichnet, dass Z und Z' als aromatischer Rest 6 bis 30 C-Atome enthalten.

7. Material gemäss Anspruch 1, dadurch gekennzeichnet, dass Z für einen Rest der Formeln V, VI, VII oder XI

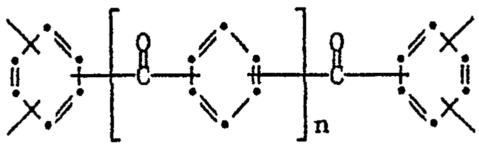 (V) ,

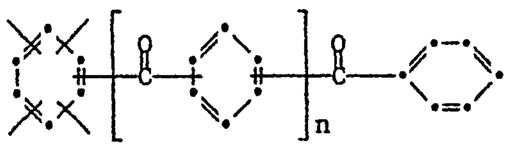 (VI) ,

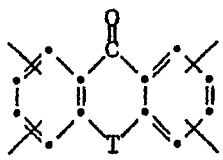 (VII) ,

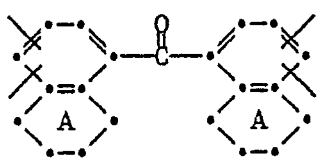 (XI) ,

steht, worin n o oder 1 ist, T eine direkte Bindung, $-CH_2-$, -O-, -S-, -SO-, $-SO_2-$, -CO-, $NR^b$ oder $-CR^bR^c$-darstellt, worin $R^b$ ein Wasserstoffatom, $C_1$-$C_{10}$-Alkyl, Napthyl oder Benzyl steht und $R^c$ die Bedeutung von $R^b$ mit Ausnahme von Wasserstoff hat, die Ringe A in Formel XI gesättigt oder aromatisch sind, und je zwei freie Bindungen in Orthostellung zueinander gebunden sind.

8. Material gemäss Anspruch 7, dadurch gekennzeichnet, das n in den Formeln V und VI o ist und T in Formel VII für -O-oder -CO-steht.

9. Material gemäss Anspruch 1, dadurch gekennzeichnet, dass Z'

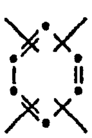 , 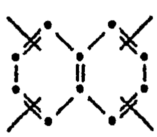 , 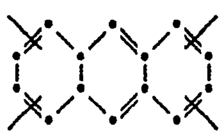 , 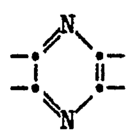 , 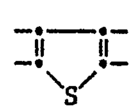 ,

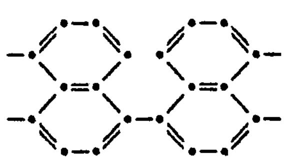 , 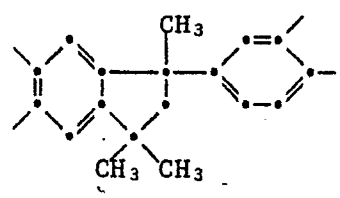 , 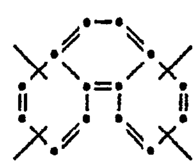 ,

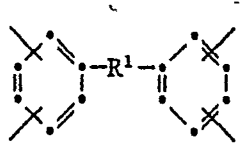

sind,

worin $R^1$ eine direkte Bindung oder eine Brückengruppe der Formeln

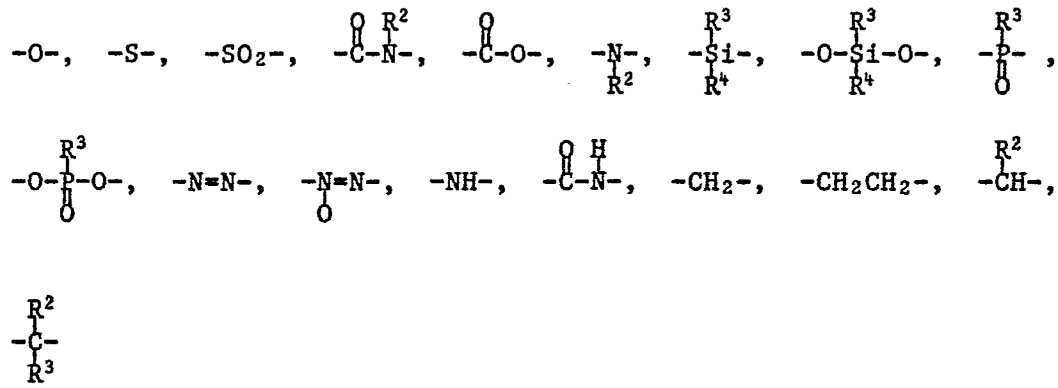

ist, worin $R^2$, $R^3$ und $R^4$ Alkyl mit 1 bis 6 C-Atomen, Phenyl oder Benzyl und $R^3$ und $R^4$ in den Si enthaltenden Gruppen Alkoxy mit 1 bis 6 C-Atomen, Phenyloxy oder Benzyloxy sind.

10. Material gemäss Anspruch 6, dadurch gekennzeichnet, dass Z' ein Rest der Formeln

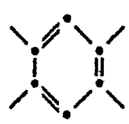 oder 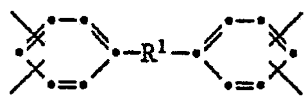 ,

ist, worin $R^1$ eine direkte Bindung, -O-, $-SO_2-$ und $CH_2$ ist.

11. Material gemäss Anspruch 1, dadurch gekennzeichnet, dass Z" in Formel IV Resten der Formeln

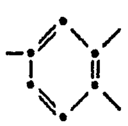 , 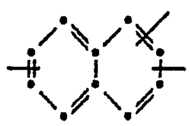 oder 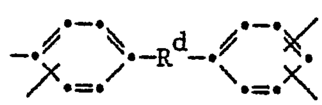

entspricht, worin $R^d$ eine Brückengruppe oder eine direkte Bindung ist.

12. Material gemäss Anspruch 1, dadurch gekennzeichnet, dass X als aromatischer Rest den Formeln VIII, VIIIa und/oder VIIIb entspricht,

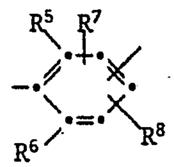 (VIII) , 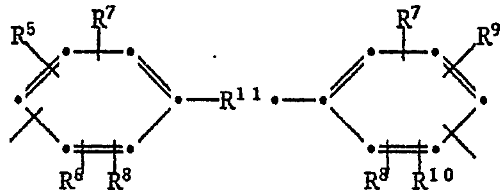 (VIIIa)

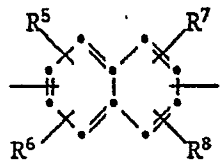 (VIIIb)

worin in Formel VIII die freien Bindungen in Meta- oder Parastellung zueinander stehen, in Formel VIIIa die freien Bindungen bevorzugt in Meta-oder Parastellung zur $R^{11}$-Gruppe stehen und $R^5$ und $R^6$ in den beiden Orthostellungen der freien Bindung gebunden sind, und in Formel VIIIb die freien Bindungen in 2-, 3-, 6-und 7-Stellung gebunden sind und $R^5$ und $R^6$ sich in den beiden Orthostellungen der freien Bindungen befinden, $R^{11}$ für eine direkte Bindung, -O-, -S-, -SS-, -SO-, $-SO_2-$, -CO-, -COO-, -NH-, -N-Alkyl mit 1 bis 6 C-Atomen im Alkyl, -N -Phenyl, -N -Benzyl, -CONH-, -CON-Alkylmit 1 bis 6 C-Atomen im Alkyl, -CON-Phenyl-, -CON-Benzyl-,

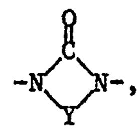, worin Y für 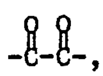, 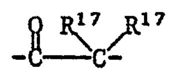 oder 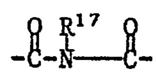 steht

und $R^{17}$ ein Wasserstoffatom, $C_1$-$C_6$-Alkyl oder Phenyl bedeutet, lineares oder verzweigtes Alkylen mit 1 bis 3 C-Atomen, gegebenenfalls durch Cl oder F substituiertes Alkyliden mit 2 bis 12 C-Atomen, Cycloalkyliden mit 5 oder 6 Ringkohlenstoffatomen, Phenylen, Phenylendioxy, oder die Gruppe $R^3$ Si $R^4$

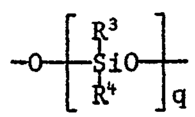 oder 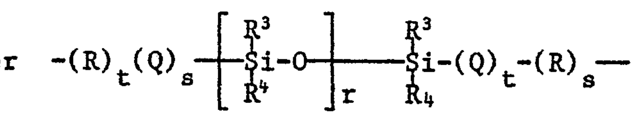 steht,

worin $R^3$ und $R^4$ Alkyl oder Alkoxy mit 1 bis 6 C-Atomen, Phenyl, Benzyl, Phenyloxy oder Benzyloxy sind, r eine Zahl von 1 bis 10, t 0 oder 1 und S 0 oder 1 ist, und R -O-oder -S-und Q $C_1$-$C_6$-Alkylen bedeuten, und q für eine Zahl von 1 bis 100 steht, $R^5$ und $R^6$ Alkyl, oder Alkoxy mit 1 bis 12 C-Atomen, Alkoxyalkyl mit 2 bis C-Atomen, Cyclopentyl, Cyclohexyl oder Benzyl sind oder in den Formeln VIII oder VIIIa $R^5$ und $R^7$ in Nachbarstellung gebunden sind und zusammen Trimethylen oder Tetramethylen bedeuten , wobei $R^6$ auch ein Wasserstoffatom sein kann, $R^7$ und $R^8$ ein Wasserstoffatom sind oder unabhängig die Bedeutung von $R^5$ und $R^6$ haben, und $R^9$ und $R^{10}$ ein Wasserstoffatom sind, unabhängig die Bedeutung von $R^5$ und $R^6$ haben oder $R^7$ und $R^8$ in Formel VIIIa zusammen Trimethylen oder Tetramethylen sind.

13. Material gemäss Anspruch 12, dadurch gekennzeichnet, dass $R^5$ und $R^6$ Alkyl mit 1 bis 6 C-Atomen, besonders Methyl, Aethyl, n-Propyl oder Isopropyl sind.

14. Material gemäss Anspruch 12, dadurch gekennzeichnet, dass $R^{11}$-$CH_2$-, -O-, -CO-oder eine direkte Bindung darstellt.

15. Material gemäss Anspruch 12, dadurch gekennzeichnet, dass in Formel VIIIa die freien Bindungen in Parastellung zur $R^{11}$-Gruppe stehen.

16. Material gemäss Anspruch 1, dadurch gekennzeichnet, dass die Polyamidsäure, der Polyamidsäurearylester oder das Polyamidsäureammoniumsalz als Copolymere mindestens 2, bevorzugt 2 bis 4 verschiedene Strukturelemente enthält.

17. Material gemäss Anspruch 16, dadurch gekennzeichnet, dass sich die Strukturelemente der Formel I im Rest X unterschieden.

18. Material gemäss Anspruch 12, dadurch gekennzeichnet, dass X in Formel I Resten der Formeln

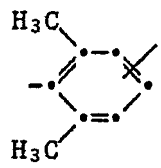 , 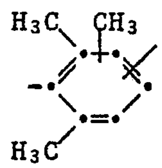 , 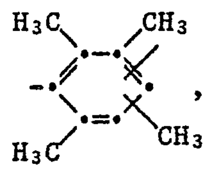 , 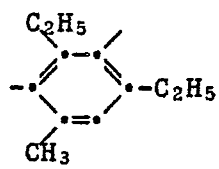

entsprechen, worin die freien Bindungen in Meta- oder Parastellung zueinander stehen, oder der Formel

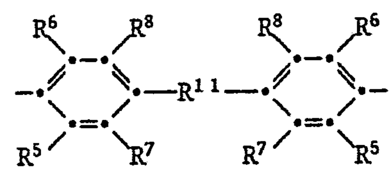

entsprechen, worin $R^5$ und $R^6$ unabhängig Methyl, Ethyl, n-Propyl oder Isopropyl und $R^7$ und $R^8$ ein Wasserstoffatom sind oder die Bedeutung von $R^5$ haben oder $R^5$ und $R^7$ zusammen Tri-oder Tetramethylen bedeuten und $R^6$ und $R^8$ ein Wasserstoffatom sind, und $R^{11}$ eine direkte Bindung, $CH_2$ oder CO ist.

19. Material gemäss Anspruch 18, dadurch gekennzeichnet, dass die Polyamidsäure oder der Polyamidsäurearylester ein Copolymer ist, worin X in Formel I zwei oder mehr Reste der Formeln

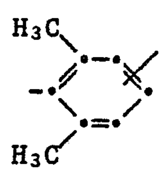 , 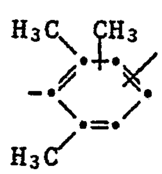 , 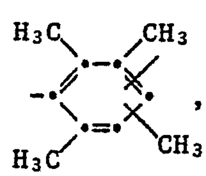 , 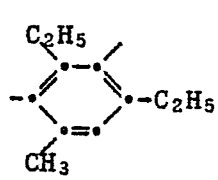

worin die freien Bindungen in Meta-oder Parastellung zueinander stehen, oder der Formel

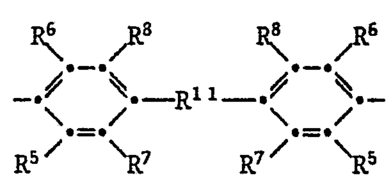

worin $R^5$, $R^6$, $R^7$, $R^8$, und $R^{11}$ die im Anspruch 18 angegebene Bedeutung haben, entspricht.

20. Material gemäss Anspruch 1, dadurch gekennzeichnet, dass X" in Formel III Alkylen mit 2 bis 30 C-Atomen, Cycloalkylen mit 5 bis 8 Ringkohlenstoffatomen, Aralkylen mit 7 bis 30 C-Atomen, Arylen mit 6 bis 22 C-Atomen oder ein Polysiloxanrest ist.

21. Material gemäss Anspruch 20, dadurch gekennzeichnet, dass X" als Arylen der Formel IX entspricht.

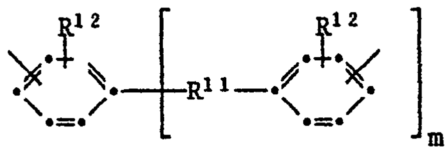

(IX)

worin m 0 oder 1 ist, die freien Bindungen in Meta- und bevorzugt in Orthostellung zur $R^{12}$-Gruppe gebunden sind, $R^{11}$ die gleiche Bedeutung wie in Formel VIIIa hat und $R^{12}$ die gleiche Bedeutung wie $R^5$hat.

22. Material gemäss Anspruch 21, dadurch gekennzeichnet, dass X" der Formel IX, IXb und/oder IXc entspricht,

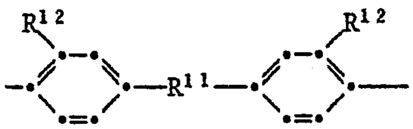

(IXa),

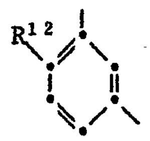

(IXb),

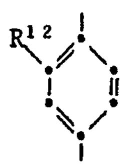

(IXc),

worin $R^{11}$ für eine direkte Bindung, -O-, -CO-, oder $-CH_2$-steht und $R^{12}$ Methyl, Ethyl, Isopropyl, Methoxy, Ethoxy oder ein Wasserstoffatom bedeutet.

23. Material gemäss Anspruch 1, dadurch gekennzeichnet, dass sie 80-100 Mol% Strukturelemente der Formel I und/oder II und 20-0 Mol% Strukturelemente der Formel III und/oder IV enthalten.

24. Material gemäss Anspruch 1, dadurch gekennzeichnet, dass weniger als 50 Mol% der Polyamidsäuren, der Polyamidsäurearylester bzw. der Polyamidsäureammoniumsalze durch entsprechende Polyamidsäureester mit einer aliphatischen Gruppe in der Estergruppe ersetzt sind.

25. Material gemäss Anspruch 1, dadurch gekennzeichnet, dass der aromatische Rest X' in Formel II ein durch Alkyl substituierter Phenylen-oder Bisphenylenrest ist.

26. Material gemäss Anspruch 25, dadurch gekennzeichnet, dass der Rest X' in der Formel II der Formel X

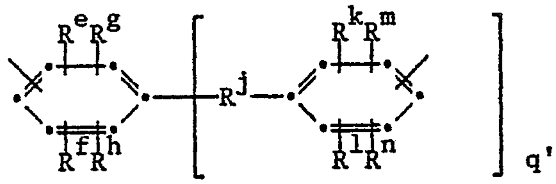

(X)

entspricht, worin q' 0 oder 1 ist, $R^j$ eine direkte Bindung oder eine Brückengruppe bedeutet, $R^l$ Alkyl mit 1 bis 4 C-Atomen und $R^g$ bis $R^n$ ein Wasserstoffatom oder Alkyl mit 1 bis 4 C-Atomen sind, und die freien Bindungen in Meta-oder Parastellung zur $R^j$-Gruppe gebunden sind.

27. Material gemäss Anspruch 26, dadurch gekennzeichnet, dass $R^j$ eine direkte Bindung und als Brückengruppe -S-. -SO-. $-SO_2-$, -CO-, $-CH_2-$, -O- oder $C_2$-$C_6$-Alkyliden bedeutet.

28. Material gemäss Anspruch 1, dadurch gekennzeichnet, dass der Rest der Formel II dem Strukturelement

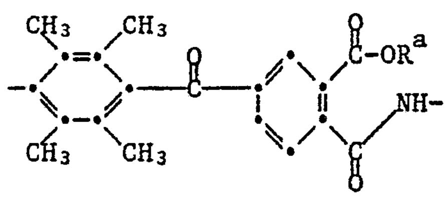

entspricht.

29. Verwendung des Materials gemäss Anspruch 1 zur Herstellung von Schutzfilmen oder photographischen Abbildungen.